# EUROPEAN PATENT SPECIFICATION

(11) **EP 2 102 868 B1**
(45) Date of publication and mention of the grant of the patent: **24.02.2016**
(21) Application number: 07865657.6
(22) Date of filing: 13.12.2007
(51) Int. Cl.: G11C 16/04, G11C 16/34, G11C 16/10

(54) **METHOD AND SYSTEM OF LOW VOLTAGE PROGRAMMING OF NON-VOLATILE MEMORY CELLS**
VERFAHREN UND SYSTEM ZUR NIEDRIGSPANNUNGSPROGRAMMIERUNG NICHT-FLÜCHTIGER SPEICHERZELLEN
PROCÉDÉ ET SYSTÈME DE PROGRAMMATION À BASSE TENSION DE CELLULES DE MÉMOIRE NON VOLATILE

(30) Priority: 21.12.2006 US 614879; 21.12.2006 US 614884
(43) Date of publication of application: 23.09.2009
(73) Proprietor: SanDisk Technologies Inc., Plano, Texas 75024 (US)
(72) Inventor: LEE, Dana, Saratoga, California 95070 (US); LUTZE, Jeffrey, San Jose, California 95125 (US)
(74) Representative: Prock, Thomas
(86) International application number: PCT/US2007/087481
(87) International publication number: WO 2008/079725

(56) References cited:
- WO-A-02/096632
- US-A1- 2006 017 085

## Description

The present invention relates generally to technology for programming memory devices. More particularly, the present invention relates to low voltage programming scheme using source side injection.

Non-volatile semiconductor memory devices, and in particular flash memory devices, are becoming increasingly popular means of storage for small devices such as digital cameras, MP3 players, cellular telephones, personal digital assistants (PDAs), laptop computers, etc. Other forms of nonvolatile memory include EPROM (Electrically Programmable Read Only Memory) and EEPROM (Electrically Erasable and Programmable Read Only Memory.

Unalike standard MOS transistors, flash memory cell transistors contain a floating gate that is electrically isolated and located between a control gate and topically a p-type substrate. Programming of a memory cell results in raising the threshold value of the transistor to a positive value as a result of electrons being injected through the insulating dielectric layer into the floating gate. Conversely, erasing results in lowering the threshold value of the transistor to a negative value as a result of electrons being removed from the floating gate. In this manner, the threshold value of the memory cell indicates its corresponding logic state. Programming is generally accomplished by using one of three major mechanisms: Fowler-Nordheim (FN) tunneling, source side [hot-electron] injection (SSI) and channel, or substrate, hot-electron injection (CHEI or SHEI).

When programming a memory cell string, there are various disturb mechanisms that tend to result in unintentional programming or erase. This problem is of particular concern when trying to program one cell on a wordline without programming the other cells on the same wordline. Since the program voltage is applied to all of the cells on a wordline during the programming of a selected cell, there exists a possibility that unselected cells may become inadvertently programmed (or erased) as well. Furthermore, the higher electric fields resulting as devices are scaled down in size and the source and drain junctions become more abrupt can lead to disturbs such as drain junction breakdown resulting in Gate Induced Drain Leakage (GIDL) whereby electrons leak into the boosted channel, and in particular, into the drain junction. Additionally, high electric fields can also lead to unintentional programming of unselected cells through FN tunneling, SSI and CHEI.

Various techniques, such as self boosting, local self boosting (LSB), and erased area self boosting (EASB), have improved the inhibition of program disturb, but still suffer from their own problems and fail to prevent program disturb in all instances. For example, in EASB, if the voltage applied to unselected wordlines is too low, channel boosting can be insufficient to prevent program disturb. Conversely, if this voltage is too high, there will be unintentional programming of memory cells on unselected wordlines as a result of tunneling. The three aforementioned techniques (and others known but not described herein) also suffer from a disturb mechanism that depends on whether or not the source-side neighbor cell is programmed. For example, if the source-side neighboring cell is programmed, it will have a negative charge on the floating gate. Since the control gate of the source side neighbor is at 0V, a highly reverse biased junction is created under the gate. This can lead to the phenomenon of GIDL resulting in a reduced boost potential, which can eventually lead to program disturb (in this case erasure). Conversely, if the source-side neighbor is erased, its threshold voltage is likely negative and the transistor of the cell may not turn off.

These programming problems, and others, become even more problematic for both selected and inhibited cells as NAND memory devices scale down to smaller geometries due to, in part, the stresses on gates and channels due to high voltages and the resultant high electric fields. Typical NAND memory fabricators attempt to manage the high voltages and electric fields using a number of approaches such as tightening distributions, selective non-scaling of certain features, or the introduction of exotic materials. Still other approaches utilize source side injection at low voltages that, unfortunately, require large memory cells, complicated fabrication processes, or both.

Therefore, what is required is a low voltage non-volatile memory programming protocol.

WO 02/096632 discloses a technique for controlling the soft-program current in virtual-ground FLASH memory arrays based on biasing the array bit-lines such that all current supplied to the array is used entirely towards the soft-programming of selected cells.

US 2006/0017085 discloses a method and system according to the preambles of the independent claims.

To achieve the foregoing and other objects of the invention, a low voltage method of programming a non-volatile memory cell is described. The low voltage programming method described is a more robust protocol suitable for reliably programming selected memory cells while eliminating programming disturbs.

In one aspect of the invention there is provided a low voltage programming method for a selected non-volatile memory cell in a NAND memory array having a gate node coupled to a wordline, hereinafter referred to as WL(n), and a drain node connected to a selected bitline. The method comprises injecting hot carriers from a drain region of an injecting memory cell having a gate node coupled to a next neighbor wordline, hereinafter referred to as WL(n-1), into a floating gate of the selected non-volatile memory cell on the wordline WL(n) by, while concurrently applying a passing voltage V_{passH} to all unselected wordlines which span the selected bitline except for the next neighbor wordline WL(n-1) and applying a program voltage V_{pgm} to the selected wordline WL(n), ramping a next neighborwordline WL(n-1) gate node voltage from about 0 V to about a voltage V_{read}.

In one embodiment, Vpgm is applied to the selected word line WL(n), the selected bitline is held at ground, a high passing voltage VpassH is applied to all unselected wordlines except for the next neighbor word line WL(n-l), the high passing voltage VpassH is also applied to a source gate select (SGS) line, all unselected bitlines are grounded, high voltage Vpp is applied to a common source line, and a next neighbor word line WL(n-l) gate node voltage is swept from about 0 V to about a Vread V.

In another embodiment, Vpgm is applied to the selected word line WL(n), the selected bitline is held at Vpp, a high passing voltage VpassH is applied to all unselected wordlines except for the next neighbor word line WL(n-l), the high passing voltage VpassH is also applied to a drain gate select (SGD) line, all unselected bitlines are grounded, a common source line is grounded, and a next neighbor word line WL(n-l) gate node voltage is swept from about 0 V to about a Vread V.

Also disclosed is a low voltage method of programming a selected non-volatile memory cell in a memory array having a gate node coupled to a wordline WL(n) and a drain node connected to a selected bitline that at least includes the following operations, if a threshold voltage of the selected non-volatile memory cell is less than a target threshold voltage, then programming the selected non-volatile memory cell by, holding the selected bitline at ground; applying Vdd to all unselected bitlines; applying low passing voltage VpasSL to SGD line; applying Vpp to common source line; applying a high passing voltage VpaSsH to all unselected wordlines except for the next neighbor word line WL(n-I); applying the high passing voltage VpasSH to a source gate select (SGS) line; applying Vpgm to the selected word line WL(n); and sweeping a next neighbor word line WL(n-l) gate node voltage from about 0 V to about a Vread, wherein hot carriers from a drain region of an injecting memory cell having a gate node coupled to a next neighbor wordline WL(n-l) are injected into a floating gate of the selected non-volatile memory cell on the wordline WL(n).

A further disclosed low voltage method of programming a selected non-volatile memory cell in a memory array having a gate node coupled to a wordline WL(n) and a drain node connected to a selected bitline, includes at least the following operations, if a threshold voltage of the selected nonvolatile memory cell is less than a target threshold voltage, then programming the selected non- volatile memory cell by, holding the selected bitline at Vpp; grounding to all unselected bitlines; applying high passing voltage VpassH to SGD line and unselected wordlines except for the next neighbor wordline WL(n-I); applying low passing voltage VpasSL to SGS line; grounding common source line; applying Vpgm to the selected word line WL(n); and sweeping a next neighbor word line WL(n-l) gate node voltage from about 0 V to about a Vreaa, wherein hot carriers from a drain region of an injecting memory cell having a gate node coupled to a next neighbor wordline WL(n-l) are injected into a floating gate of the selected non-volatile memory cell on the wordline WL(n).

In another aspect of the invention there is provided a system for providing low voltage programming of a selected non-volatile memory cell in a NAND memory array having a gate node coupled to a wordline WL(n) and a drain node connected to a selected bitline. The system comprises a programming module, an interface arranged to electrically couple the memory array to the programming module, a processor included in the programming module and electrically coupled to the interface and arranged to execute programming instructions that cause hot carriers to be injected from a drain region of an injecting memory cell having a gate node coupled to a next neighbor wordline WL(n-1) into a floating gate of the selected non-volatile memory cell on the wordline WL(n). The programming instructions further include computer code executable by the processor for, while concurrently applying a passing voltage V_{passH} to all unselected wordlines which span the selected bitline except for the next neighborwordline WL(n-1) and applying a program voltage V_{pgm} to the selected word line WL(n), ramping a next neighbor wordline WL(n-1) gate node voltage from about 0V to about a voltage V_{read}.

In one embodiment, Vpgm is applied to the selected word line WL(n), the selected bitline is held at ground, a high passing voltage VpassH is applied to all unselected wordlines except for the next neighbor word line WL(n-l), the high passing voltage VpassH is also applied to a source gate select (SGS) line, all unselected bitlines are grounded, high voltage Vpp is applied to a common source line, and a next neighbor word line WL(n-l) gate node voltage is swept from about 0 V to about a Vread V.

In another embodiment, Vpgm is applied to the selected word line WL(n), the selected bitline is held at Vpp, a high passing voltage VpassH is applied to all unselected wordlines except for the next neighbor word line WL(n-l), the high passing voltage VpassH is also applied to a drain gate select (SGD) line, all unselected bitlines are grounded, a common source line is grounded, and a next neighbor word line WL(n-l) gate node voltage is swept from about 0 V to about a Vread V.

A further system for providing low voltage programming of a selected non-volatile memory cell in a memory array having a gate node coupled to a wordline WL(n) and a drain node connected to a selected bitline, includes at least a programming module; an interface arranged to electrically couple the memory array to the programming module; and a processor included in the programming module and electrically coupled to the interface for executing programming instructions only if a threshold voltage of the selected non-volatile memory cell is less than a target threshold voltage that include holding the selected bitline at ground, applying Vdd to all unselected bitlines; applying low passing voltage VpassL to SGD line, applying Vpp to common source line, applying a high passing voltage VpassH to all unselected wordlines except for the next neighbor word line WL(n-l), applying the high passing voltage VpassH to a source gate select (SGS) line, applying Vpgm to the selected word line WL(n), and sweeping a next neighbor word line WL(n-l) gate node voltage from about 0 V to about a Vread thereby causing hot carriers to be injected from a drain region of an injecting memory cell having a gate node coupled to a next neighbor wordline WL(n-l) into a floating gate of the selected non-volatile memory cell on the wordline WL(n), otherwise, if the threshold voltage is greater than an target threshold voltage, the non-volatile memory cell is locked out.

Also disclosed is a system for providing low voltage programming of a selected non-volatile memory cell in a memory array having a gate node coupled to a wordline WL(n) and a drain node connected to a selected bitline. The system includes at least a programming module; an interface arranged to electrically couple the memory array to the programming module; and a processor included in the programming module and electrically coupled to the interface for executing programming instructions only if a threshold voltage of the selected non-volatile memory cell is less than a target threshold voltage that include holding the selected bitline at Vₚₚ grounding to all unselected bitlines, applying high passing voltage VpassH to SGD line and unselected wordlines except for the next neighbor wordline WL(n-1), applying low passing voltage V_{passL} to SGS line; grounding common source line, applying V_{pgm} to the selected word line WL(n), and sweeping a next neighbor word line WL(n-1) gate node voltage from about 0 V to about a V_{read} when the threshold voltage is less than the target voltage thereby causing hot carriers to be injected from a drain region of an injecting memory cell having a gate node coupled to a next neighbor wordline WL(n-1) into a floating gate of the selected non-volatile memory cell on the wordline WL(n), otherwise, if the threshold voltage is greater than an target threshold voltage, the non-volatile memory cell is locked out.

In the described embodiments the non-volatile memory cell is one of a number of non-volatile memory cells arranged to form a non-volatile memory array suitable for storing data. The non-volatile memory array is arranged in a NAND-type memory array architecture having a number of wordlines and bitlines. Additionally, the described method is contemplated for use on a multilevel type memory array that when programmed stores data in the form of at least one lower page and at least one associated upper page.

The invention, together with further objects and advantages thereof, may best be understood by reference to the following description taken in conjunction with the accompanying drawings.
Fig. 1 illustrates an exemplary MOSFET having a floating gate.
Fig. 2 illustrates an exemplary non-volatile memory string.
Fig- 3 illustrates an exemplary non-volatile memory array.
Fig. 4 shows a flowchart illustrating a low voltage method of programming a non-volatile memory cell in accordance with an embodiment of the present invention.
Fig. 5 shows a schematic representation of the programming described in Fig. 4.
Fig. 6 illustrates a representative low voltage programming voltage bias values in accordance with the embodiment of the invention described in Figs. 4 and 5.
Fig. 7 shows a flowchart illustrating a method of programming non-volatile memory cell located on a wordline WL(n) using a next neighbor wordline WL(n-1) as a hot carrier injector using source side injection (SSI) in accordance with an embodiment of the invention.
Fig. 8 shows a schematic representation of the programming described in Fig. 7.
Figs. 9A and 9B illustrates representative low voltage programming waveforms in accordance with the embodiment of the invention described with regards to Figs. 7 and 8.

In the drawings, like reference numerals designate like structural elements. Also, it should be understood that the depictions in the figures are not to scale.

In the following description, numerous specific details are set forth in order to provide a thorough understanding of the present invention. It will be apparent, however, to one skilled in the art that the present invention may be practiced without some or all of these specific details. In the description below, a memory cell is programmed using a next neighbor wordline as an injector for providing hot carriers. The objective is to use low voltage biasing to prevent and therefore substantially eliminate programming problems related to high voltage, small geometries, and resultant high electric fields.

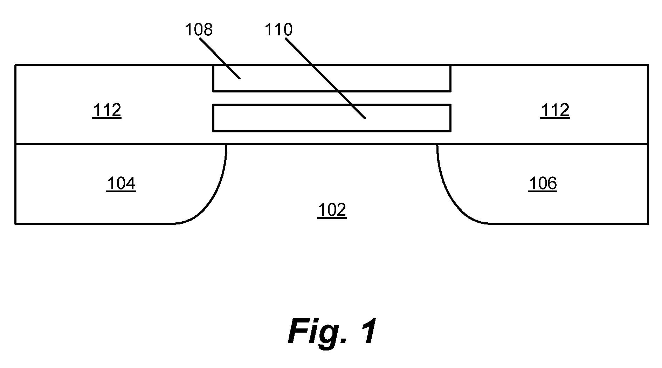

With reference to Figs- 1, 2 and 3 a representative non-volatile memory storage array will be described, In the described embodiment, the non-volatile memory storage system is a flash memory chip having a NAND architecture, although the present invention is applicable to other forms of non-volatile memory including EPROM and EEPROM, and additionally to NOR architectures as well. In the described embodiment, the array consists of non-volatile memory storage elements that are p-type substrate floating gate MOSFETs. Fig. 1 illustrates a representative floating gate MOSFET, such as that used in this architecture, having a substrate 102, a source 104, a drain 106, a control gate 108, a floating gate 110, and a dielectric 112 surrounding the floating gate.

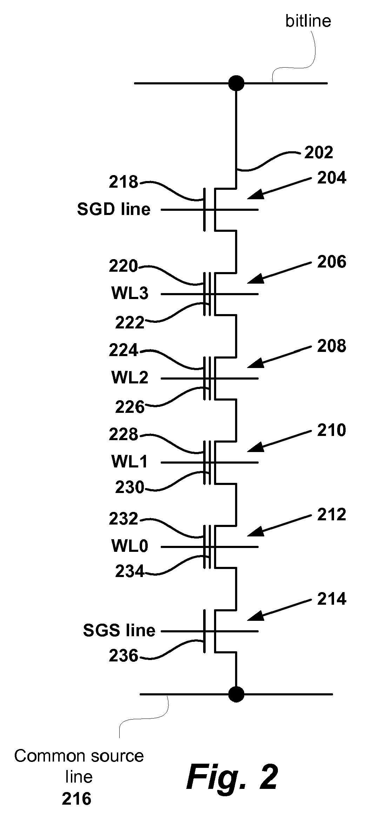

In NAND flash memory, a number of such transistors, also known hereafter as cells, memory cells or memory storage elements, are arranged in series. On either side of the series of memory cells is an additional transistor known as a select transistor, or gate. Collectively, the memory cells and two select gates are referred to as a NAND string. By way of illustration, the equivalent circuit of a 4-transistor NAND string is illustrated in Fig. 2. The four memory cells are labeled 206, 208, 210 and 212. The first select gate 204, referred to as the select gate drain (SGD), connects the NAND string to bitline 202. The second select gate 214, referred to as the select gate source (SGS), connects the NAND string to source line 216. Select gates 204 and 214 are controlled by control gates 218 and 236, respectively. An SGD line controls the control gate 218 for the select gate 204, while an SGS line controls the control gate 236 for the select gate 214. The four series transistors 206 - 212 each have both a control gate and a floating gate. For example, transistor 206 has a control gate 220 and a floating gate 222; transistor 208 has a control gate 224 and a floating gate 226; transistor 210 has a control gate 228 and a floating gate 230; and transistor 212 has a control gate 232 and a floating gate 234. Control gates 220, 224, 228 and 232 are connected to wordlines WL(3), WL(2), WL(1) and WL(0), respectively. It should be noted that although the example provided describes a NAND string that includes four memory cells, other numbers of cells may be arranged in series and are permissible as well.

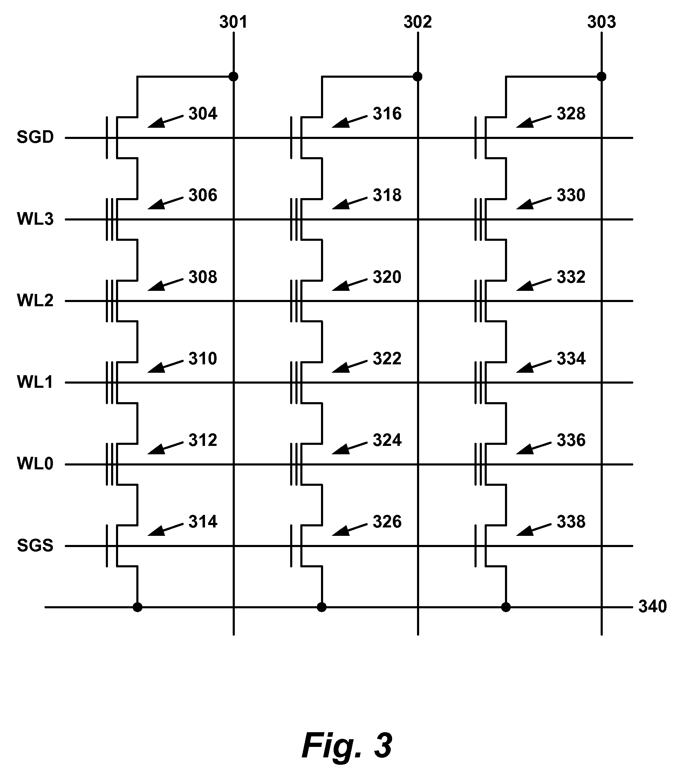

Fig. 3 illustrates an example of a NAND string array showing three NAND strings 301, 302 and 303 of a memory array having many more NAND strings not shown. Like the string of Fig. 2, each of the NAND strings of Fig. 3 includes two select gates and four memory cells. For example, NAND string 301 includes select gates 304 and 314 as well as memory cells 306, 308, 310 and 312. Similarly, NAND string 302 includes select gates 316 and 326 as well as memory cells 318, 320, 322 and 324. Finally, NAND string 303 includes select gates 328 and 338 as well as memory cells 330, 332, 334 and 336. It should be noted that all control gates in a given row, or wordline, are connected. For example, WL0 connects the control gates of memory cells 312, 324 and 336. Each of the NAND strings are also connected to the same source line 340 via select gates 314, 326 and 338. The SGS line controls the source side select gates 314, 326, and 338, while the SGD line controls the select gates 304, 316 and 328, which connect the NAND strings to their respective bitlines.

While it is desired that the programming operation proceed as fast as possible, it is also desired that the Vt distributions be tight (narrow) such that a wider read margin (distance between the distributions) is obtained. It should also be noted that if multiple effects such as SSI, GIDL or SHEI occur, these effects are cooperative. That is, SSI, GIDL, and SHEI all move the selected distributions in the same direction. Therefore, even in the presence of multiple effects, unanticipated disturb will not occur. At most, these effects would cause variations in the programming rate. Furthermore, since the unselected bitlines are at zero or low bias (V_{dd}), GIDL, SSI and SHEI should not occur on unselected bitlines. However, there does exist a need to ensure that V_{pgm} and Vₚₐₛₛ are low enough to prevent Vₚₐₛₛ disturbances due to tunneling..

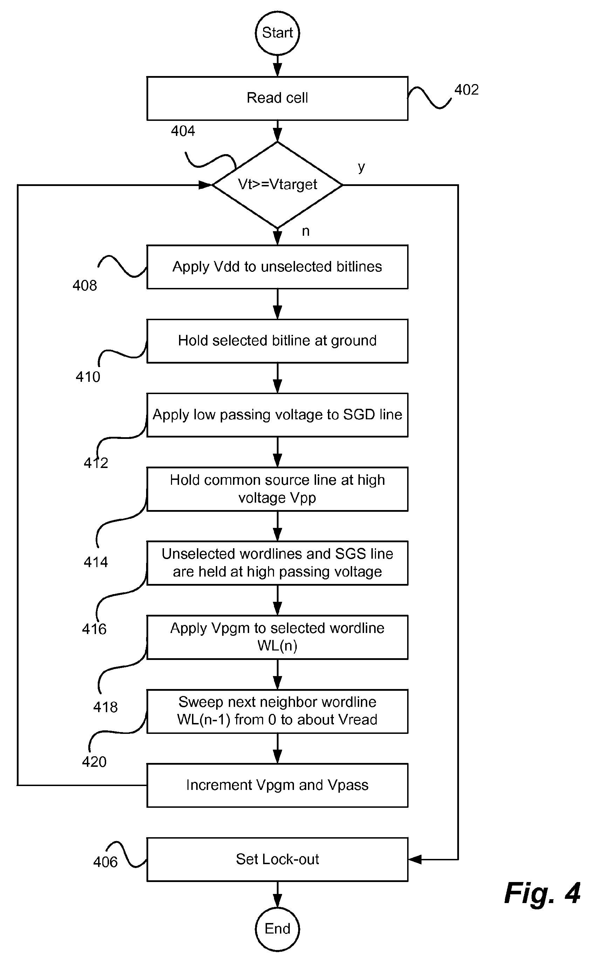

Fig. 4 shows a flowchart illustrating a method of programming non-volatile memory cell located on a wordline WL(n) using a next neighbor wordline WL(n-1) as a hot carrier injector using source side injection (SSI) in accordance with an embodiment of the invention. It should be noted that SSI is a method of programming whereby electrons are injected from the drain of one transistor into the gate above the source of an adjacent transistor. In the described embodiment, the cell to be programmed is first subjected to a read operation 402. During the read operation, the threshold voltage of the memory cell is verified. In step 404 it is then determined whether or not a target verification voltage level, V_{target}, is reached. If the threshold voltage of the memory cell is greater than or equal to V_{target}, the cell is locked-out in step 406. If the threshold voltage is less than T_{arget}, then in step 408 unselected bitlines are held at V_{dd} while, in step 410, the selected bitline is grounded. In step 412, the SGD line is held at low passing voltage V_{passL} (about 2V), while, in step 414, the source line is held at Vₚₚ (about 5V). In step 416, unselected wordlines and SGS line are held at a high passing voltage, V_{passH} (about 8V), and at step 418, a high positive program voltage, V_{pgm}, is applied to the control gate of the selected memory cell by biasing wordline WL(n) and at step 420 next neighbor wordline WL(n-1) is swept from about 0V to about V_{read}. In this manner, the floating gate of the selected cell on wordline WL(n) serves as a collector of electrons and the next neighbor wordline WL(n-1) serves as the injector. Next, V_{pgm} and V_{pass_x} (both V_{passH} and V_{passL}) are incremented in step 422 and the process is repeated until the condition 404 is satisfied. It should be noted that sample bias conditions include: V_{pgm} ranges from about 8V to about 14V, V_{passL} ranges from about 4V to about 10V, V_{passH} ranges from about 5V to about 10V, Vₚₚ ranges from about 3.5V to about 5.5V, and V_{dd} ranges from about 1.8V to about 3.6V.

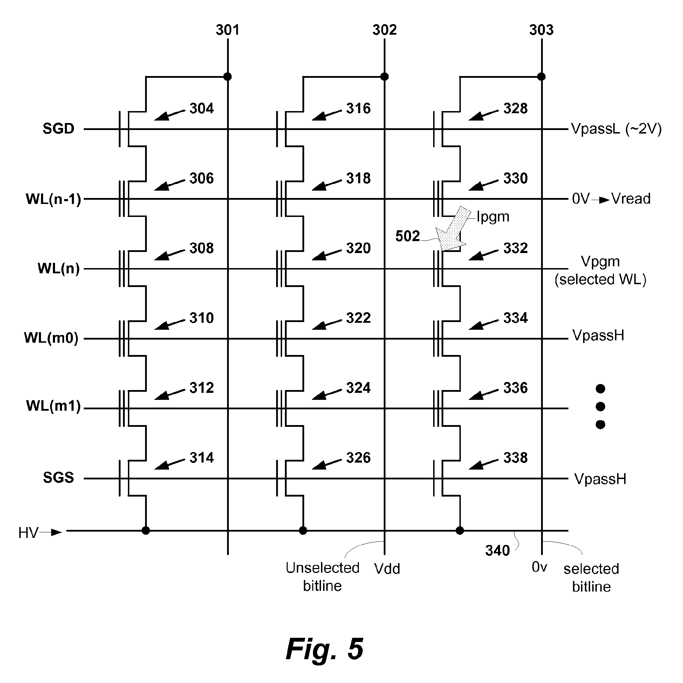

The bias conditions described with respect to the embodiment described with regards to process 400 above for next neighbor wordline WL(n-1) programming are illustrated in Fig. 5, where a selected memory cell 332 on WL(n) is being programmed by electrons provided by memory cell 330 on next neighbor wordline WL(n-1). Adjacent to the cell 330 are a select gate drain 328 connected to an SGD line on which voltage VSGD is applied. The arrow 502 indicates the direction the electrons that constitute programming current I_{pgm} are traveling. When the word line WL(n-1) is ramped from 0 to V_{read}, a conducting channel of electrons is created between its source and drain. The large V_{pgm} applied to the control gate of cell 332 causes electrons in the source of memory cell 330 to be injected into the floating gate of the cell 332.

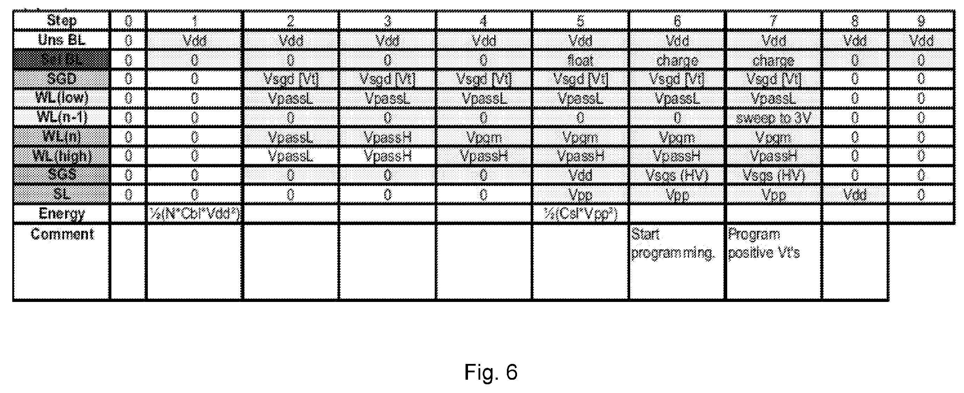

Fig. 6 illustrates a representative low voltage programming bias voltage values in accordance with the embodiment of the invention described in Figs. 4 and 5.

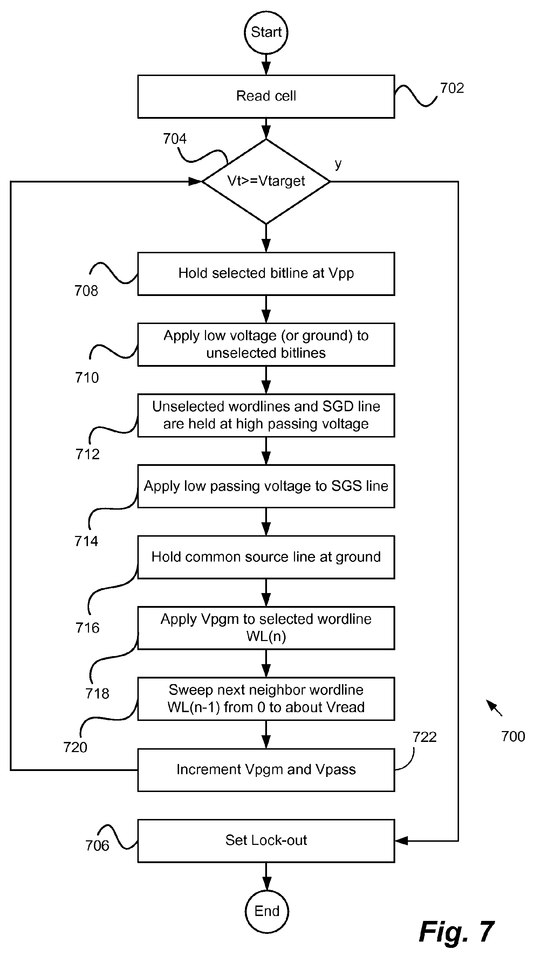

Fig. 7 shows a flowchart illustrating a method of programming non-volatile memory cell located on a wordline WL(n) using a next neighbor wordline WL(n-1) as a hot carrier injector using source side injection (SSI) in accordance with an embodiment of the invention. It should be noted that the "S" in "SSI" actually refers to the "source region of WL(n)" which happens to be the same electrical node as the "drain region of WL(n-1). In the described embodiment, the memory cell to be programmed is first subjected to a read operation 702. During the read operation, the threshold voltage of the memory cell is verified. In step 704 it is then determined whether or not a target verification voltage level, V_{target}, is reached. If the threshold voltage of the memory cell is greater than or equal to V_{target}, the cell is locked-out in step 706. If the threshold voltage is less than V_{target}, then in step 708 the selected bitline is held at Vₚₚ at step 710, unselected bitlines are held at ground or other low voltage V_{dd} and at 712, unselected wordlines and SGD line are held at a high passing voltage, V_{passH} (about 8V). In step 714, the SGS line is held at low passing voltage V_{passL} (about 2V) while, in step 716, the source line is held at ground and at step 718, a high positive program voltage, V_{pgm}, is applied to the control gate of the selected memory cell by biasing wordline WL(n) and at step 720 next neighbor wordline WL(n-1) is swept from about 0V to about V_{read}. In this manner, the floating gate of the selected cell on wordline WL(n) serves as a collector of electrons and the next neighbor wordline WL(n-1) serves as the injector. Next, V_{pgm} and V_{pass_x} (both V_{passH} and V_{passL}) are incremented in step 722 and the process is repeated until the condition 704 is satisfied.

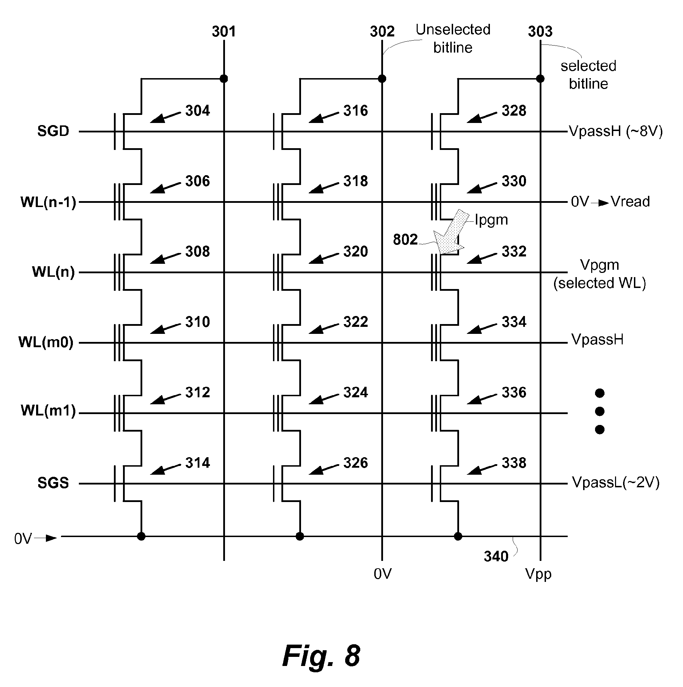

The bias conditions described with respect to the embodiment described with regards to process 800 above for next neighbor wordline WL(n-1) programming are illustrated in Fig. 8, where the selected memory cell 332 on WL(n) is being programmed by electrons provided by memory cell 330 on next neighbor wordline WL(n-1). The arrow 802 indicates the direction the electrons that constitute programming current I_{pgm} are traveling. As above with regards to the process 400, when the word line WL(n-1) is ramped from 0 to V_{read}, a conducting channel of electrons is created between its source and drain. The large V_{pgm} applied to the control gate of cell 332 causes electrons in the source of memory cell 330 to be injected into the floating gate of the cell 332.

It should be noted that other biasing schemes for programming with SSI are well known in the art and are permitted as well. For example, there are boost-based schemes for boosting the channel voltage in a selected memory cell. In such schemes, the selected wordline is often biased to Vdd while unselected wordlines are biased with a voltage, Vboost, which is greater than Vpass. Such boosting schemes take advantage of the channel capacitance of unselected cells. Hence, the strength of boosting increases as the number of wordlines increases and scales down as the device geometries scale down. Alternatively, the much larger BL capacitance can be used to provide the boost.

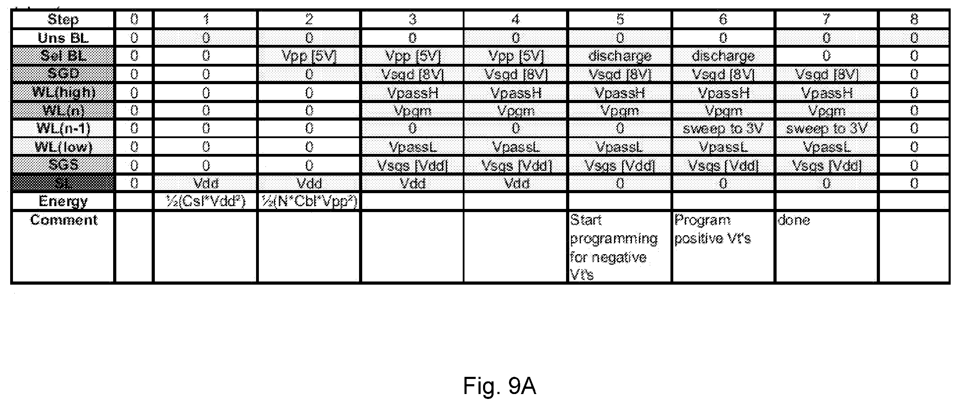

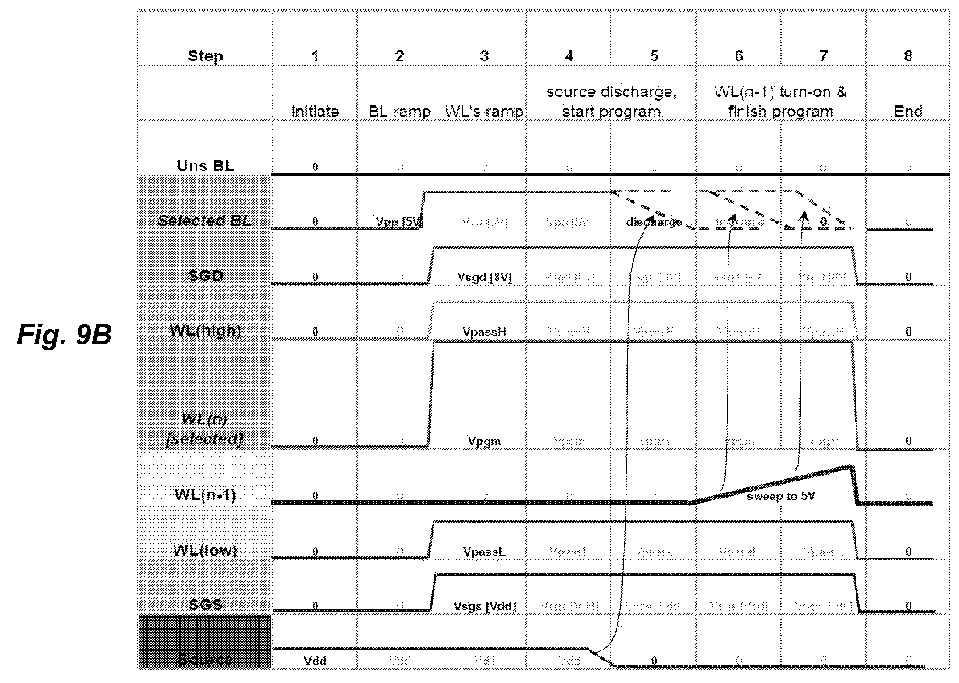

Figs. 9A and 9B illustrates representative low voltage programming waveforms and corresponding bias voltages in accordance with the embodiment of the invention described with regards to Figs. 7 and 8.

It should be additionally noted that SSI is very efficient in generating hot electrons in the channel of the selected transistor receiving the electrons and also provides very high efficiency in collecting these channel hot electrons into the floating gate. SSI also requires significantly less current than other modes of programming, improves reliability and allows for re-programming using on-chip charge pumps. Furthermore, by using a next neighbor word line as an injector, the programming voltage Vpgm is reduced over conventional FN programming methods, the channel voltage Vpp is reduced, there is no change in already existing NAND architecture, there is no reliance on tunnel oxide scaling, and any of a number of programming protocols are available.

Although specific features and conditions have been described, it should be appreciated that a wide variety of implementations, such as bias conditions and method combinations, may be modified and employed as well. In addition, although in physical construction the present invention is applied to a conventional non-volatile memory system without modification, it should be appreciated by one skilled in the art that the structure could be modified to enhance the effects of the present invention. Accordingly, the present embodiments are to be considered as illustrative and not restrictive and the invention is not to be limited to the details given herein, but may be modified within the scope of the appended claims.

## Claims

1. A low voltage programming method for a selected non-volatile memory cell (332) in a NAND memory array having a gate node coupled to a wordline, hereinafter referred to as WL(n) and a drain node connected to a selected bitline (303);
**characterized by**:
injecting hot carriers from a drain region of an injecting memory cell (330) having a gate node coupled to a next neighbor wordline, hereinafter referred to as WL(n-1), into a floating gate of the selected non-volatile memory cell (332) on the wordline WL(n) by:
while concurrently applying a passing voltage V_{passH} to all unselected wordlines which span the selected bitline (303) except for the next neighbor word line WL(n-1) and applying a program voltage V_{pgm} to the selected wordline WL(n), ramping a next neighbor wordline WL(n-1) gate node voltage from about 0V to about a voltage V_{read}.

2. A method according to Claim 1 including the steps of:
(b) determining a threshold voltage of the selected non-volatile memory cell (332); and
(c) locking out the selected non-volatile memory (332) cell if the threshold voltage is greater than an target threshold voltage.

3. A method according to Claim 2 wherein the threshold voltage is less than the target voltage, further comprising:
holding the selected bitline (303) at ground;
applying a voltage V_{dd} to all unselected bitlines (301, 302);
applying a passing voltage V_{passL} to a drain gate select line;
applying a voltage Vₚₚ to common source line;
applying the passing voltage V_{passH} to a source gate select line.

4. A low voltage programming method as recited in Claim 2 wherein the threshold voltage is less than the target voltage, further comprising:
holding the selected bitline (303) at a voltage Vₚₚ;
grounding to all unselected bitlines (301, 302);
applying passing voltage V_{passH} to a drain gate select line;
applying a passing voltage V_{passL} to source gate select line;
grounding common source line.

5. A method according to Claim 3 or Claim 4 including the steps of:
incrementing the program voltage V_{pgm} and the V_{passH} and V_{passL} voltages; and
returning to determining (b).

6. A method according to any of Claims 3 to 5 wherein V_{pgm} ranges from 8V to 14V, V_{passL} ranges from 4V to 10V, V_{passH} ranges from 5V to 10V, Vₚₚ ranges from 3.5V to 5.5V, and V_{dd} ranges from 1.8V to 3.6V.

7. A system for providing low voltage programming of a selected non- volatile memory cell (332) in a NAND memory array having a gate node coupled to a wordline WL(n) and a drain node connected to a selected bitline (303), comprising:
a programming module;
an interface arranged to electrically couple the memory array to the programming module;
**CHARACTERIZED BY**:
a processor included in the programming module and electrically coupled to the interface and arranged to execute programming instructions that cause hot carriers to be injected from a drain region of an injecting memory cell (330) having a gate node coupled to a next neighbor wordline WL(n-1) into a floating gate of the selected non-volatile memory cell (332) on the wordline WL(n);
wherein the programming instructions further include computer code executable by the processor for:
while concurrently applying a passing voltage V_{passH} to all unselected wordlines which span the selected bitline (303) except for the next neighbor wordline WL(n-1) and applying a program voltage V_{pgm} to the selected wordline WL(n), ramping a next neighbor wordline WL(n-1) gate node voltage from about 0V to about a voltage V_{read}.

8. A system according to Claim 7, wherein the programming instructions include computer code executable by the processor for:
(b) determining a threshold voltage of the selected non-volatile memory cell (332); and
(c) locking out the selected non-volatile memory cell (332) if the threshold voltage is greater than an target threshold voltage.

9. A system according to Claim 8, wherein the programming instructions further include computer code executable by the processor, when the threshold voltage is less than the target voltage, for:
holding the selected bitline (303) at ground;
applying a voltage V_{dd} to all unselected bitlines (301, 302);
applying a passing voltage V_{passL} to a drain gate select line;
applying a voltage Vₚₚ to common source line;
applying the passing voltage V_{passH} to a source gate select line.

10. A system according to Claim 8, wherein the programming instructions further include computer code executable by the processor, when the threshold voltage is less than the target voltage, for,
holding the selected bitline (303) at Vₚₚ;
grounding to unselected bitlines (301, 302);
applying passing voltage V_{passH} to a drain gate select line;
applying passing voltage V_{passL} to a source gate select line;
grounding a common source line.

11. A system according to Claim 9, wherein the programming instructions further include computer code executable by the processor for:
incrementing the program voltage V_{pgm} and the V_{passH} and V_{passL} voltages; and
returning to determining (b).

12. A system according to any of Claims 9 to 11, wherein V_{pgm} ranges from 8V to 14V, V_{passL} ranges from 4V to 10V, V_{passH} ranges from 5V to 10V, Vₚₚ ranges from 3.5V to 5.5V, and V_{dd} ranges from 1.8V to 3.6V.

## Patentansprüche

1. Verfahren zur Niedrigspannungsprogrammierung für eine ausgewählte nichtflüchtige Speicherzelle (332) in einem NAND Speicherbereich, aufweisend einen an einer Wortleitung gekoppelten Gate Knoten, im folgenden als WL(n) bezeichnet und einen an einer ausgewählten Bitleitung (303) verbundenen Drain Knoten;
**gekennzeichnet durch**:
Injizieren von Hot-Carriers aus einer Drain-Region einer injizierenden Speicherzelle (330) mit einem an einer nächsten Nachbar-Wortleitung gekoppelten Gate-Knoten, im folgenden als WL(n-1) bezeichnet, in einen Floating Gate der ausgewählten nicht flüchtigen Speicherzelle (332) auf der Wortleitung WL(n) **durch**:
Hochlaufen, während des gleichzeitigen Anlegens einer durchgehenden Spannung V_{passH} auf alle nicht ausgewählten Wortleitungen, welche di ausgewählte Bitleitung (303) umfassen, mit der Ausnahme der nächsten Nachbar-Wortleitung WL(n-1) und Anlegen einer Programmspannung V_{pgm} auf der ausgewählten Wortleitung WL(n), einer Gate-Knoten-Spannung der nächsten Nachbar-Wortleitung WL(n-1) von etwa 0 V bis zu einer Spannung von etwa V_{read}.

2. Verfahren nach Anspruch 1, umfassend die Schritte von:
(b) Bestimmen einer Schwellspannung der ausgewählten nichtflüchtigen Speicherzelle (332); und
(c) Aussperren der ausgewählten nichtflüchtigen Speicherzelle (332) falls die Schwellspannung größer als eine Zielschwellspannung ist.

3. Verfahren nach Anspruch 2, wobei die Schwellspannung kleiner als die Zielspannung ist, ferner umfassend:
Beibehalten der Erdung der ausgewählten Bitleitung (303);
Anlegen einer Spannung V_{dd} an alle nicht gewählten Bitleitungen (301 ,302);
Anlegen einer durchgehenden Spannung V_{passL} an die Drain-Gate-Select-Leitung;
Anlegen einer Spannung Vₚₚ, an die gemeinsame Source-Leitung,
Anlegen der durchgehenden Spannung V_{passH} an eine Source-Gate-Select-Leitung.

4. Verfahren zur Niedrigspannungsprogrammierung nach Anspruch 2, wobei die Schwellspannung kleiner als die Zielspannung ist, ferner umfassend:
Halten der Spannung Vₚₚ, an der ausgewählten Bitleitung (303);
Erdung aller nicht ausgewählten Bitleitungen (301, 302);
Anlegen einer durchgehenden Spannung V_{passH} an eine Drain-Gate-Select-Leitung;
Anlegen einer durchgehenden Spannung Vp_{assL} an die Source-Gate-Select-Leitung;
Erdung der gemeinsamen Source-Leitung.

5. Verfahren nach Anspruch 3 oder 4, umfassend die Schritte von:
Erhöhen der Programmspannung V_{pgm} und der V_{passH} und V_{passL} Spannungen; und
Zurückkehren zur Bestimmung von (b).

6. Verfahren nach einem der Ansprüche 3 bis 5, wobei V_{pgm} zwischen 8 V und 14 V liegt, V_{passL} zwischen 4 V und 10 V liegt, V_{passH} zwischen 5 V und 10 V liegt, Vₚₚ zwischen 3,5 V und 5,5 V liegt, und V_{dd} zwischen 1,8 V und 3,6 V liegt.

7. System zur Niedrigspannungsprogrammierung für eine ausgewählte nichtflüchtige Speicherzelle (332) in einem NAND Speicherbereich, aufweisend einen Gate Knoten, der an eine Wortleitung WL(n) gekoppelt ist und einen Drain Knoten, der an einer ausgewählten Bitleitung (303) verbunden ist, umfassend:
ein Programmiermodul;
eine Schnittstelle, die dafür vorgesehen ist den Speicherbereich elektrisch mit den Programmiermodul zu koppeln;
**gekennzeichnet durch**:
einen im Programmiermodul enthaltenen und elektrisch mit der Schnittstelle gekoppelten Prozessor, der dafür vorgesehen ist, Programmierungsanweisungen durchzuführen, die das Injizieren von Hot Carriers aus einer Drain-Region einer injizierenden Speicherzelle (330) mit einem an einer nächsten Nachbar-Wortleitung WL(n-1) gekoppelten Gate Knoten in einen Floating Gate der ausgewählten nicht flüchtigen Speicherzelle (332) auf der Wortleitung WL(n) verursachen;
wobei die Programmierungsanweisungen ferner einen vom Prozessor ausführbaren Computer-Code umfassen, um:
während des gleichzeitigen Anlegens einer Spannung V_{passH} an alle nicht ausgewählten Wortleitungen, welche die ausgewählte Bitleitung (303) umfassen, mit Ausnahme der nächsten Nachbar-Wortleitung WL(n-1) und Anlegen einer Programmspannung V_{pgm} an der ausgewählten Wortleitung WL(n), die Gate-Knoten-Spannung einer nächsten Nachbar-Wortleitung WL(n-1) von etwa 0 V bis zu einer Spannung von etwa V_{read} hochzulaufen.

8. System nach Anspruch 7, wobei die Programmierungsanweisungen einen vom Prozessor ausführbaren Computer Code umfassen, zum:
(b) Bestimmen einer Schwellspannung der ausgewählten nichtflüchtigen Speicherzelle (332); und
(c) Aussperren der ausgewählten nichtflüchtigen Speicherzelle (332) falls die Schwellspannung größer als eine Zielschwellspannung ist.

9. System nach Anspruch 8, wobei die Programmierungsanweisungen ferner einen vom Prozessor ausführbaren Computer Code umfassen, wenn die Schwellspannung kleiner als die Zielspannung ist, zum
Beibehalten der Erdung der ausgewählten Bitleitung (303);
Anlegen einer Spannung V_{dd} an alle nicht gewählten Bitleitungen (301 ,302);
Anlegen einer durchgehenden Spannung V_{passL} an eine Drain-Gate-Select-Leitung;
Anlegen einer Spannung Vₚₚ auf die gemeinsame Source-Leitung;
Anlegen der durchgehenden Spannung V_{passH} an eine Source-Gate-Select-Leitung.

10. System nach Anspruch 8, wobei die Programmierungsanweisungen ferner einen vom Prozessor ausführbaren Computer Code umfassen, wenn die Schwellspannung kleiner als die Zielspannung ist, zum
Halten der Spannung Vₚₚ an der ausgewählten Bitleitung (303);
Erdung aller nicht ausgewählten Bitleitungen (301, 302);
Anlegen einer durchgehenden Spannung V_{passH} an eine Drain-Gate-Select-Leitung;
Anlegen einer durchgehenden Spannung Vp_{assL} an eine Source-Gate-Select-Leitung;
Erdung einer gemeinsamen Source-Leitung.

11. System nach Anspruch 9, wobei die Programmierungsanweisungen ferner einen vom Prozessor ausführbaren Computer Code umfassen, zum
Erhöhen der Programmspannung V_{pgm} und der V_{passH} und V_{passL} Spannungen; und
Zurückkehren zur Bestimmung von (b).

12. System nach einem der Ansprüche 9 bis 11, wobei V_{pgm} zwischen 8 V und 14 V liegt, V_{passL} zwischen 4 V und 10 V liegt, V_{passH} zwischen 5 V und 10 V liegt, Vₚₚ zwischen 3,5 V und 5,5 V liegt, und V_{dd} zwischen 1,8 V und 3,6 V liegt.

## Revendications

1. Procédé de programmation à basse tension d'une cellule de mémoire non volatile sélectionnée (332) dans une matrice de mémoire NON-ET présentant un noeud de grille couplé à une ligne de mots, ci-après appelée WL(n), et un noeud de drain connecté à une ligne de bits sélectionnée (303) ;
**caractérisé par** l'étape ci-dessous consistant à :
injecter des charges à haute énergie à partir d'une région de drain d'une cellule de mémoire d'injection (330) présentant un noeud de grille couplé à une ligne de mots voisine successive, ci-après appelée WL(n-1), dans une grille flottante de la cellule de mémoire non volatile sélectionnée (332) sur la ligne de mots WL(n) en :
tout en appliquant simultanément une tension de passage V_{passH} à toutes les lignes de mots non sélectionnées qui englobent la ligne de bits sélectionnée (303), à l'exception de la ligne de mots voisine successive WL(n-1), et en appliquant une tension de programme V_{pgm} à la ligne de mots sélectionnée WL(n), augmenter progressivement une tension de noeud de grille de ligne de mots voisine successive WL(n-1) d'environ 0 V à environ une tension V_{read}.

2. Procédé selon la revendication 1, comprenant les étapes ci-dessous consistant à :
(b) déterminer une tension de seuil de la cellule de mémoire non volatile sélectionnée (332) ; et
(c) verrouiller la cellule de mémoire non volatile sélectionnée (332) si la tension de seuil est supérieure à une tension de seuil cible.

3. Procédé selon la revendication 2, dans lequel la tension de seuil est inférieure à la tension cible, comprenant en outre les étapes ci-dessous consistant à :
maintenir la ligne de bits sélectionnée (303) à la terre ;
appliquer une tension V_{dd} à toutes les lignes de bits non sélectionnées (301, 302) ;
appliquer une tension de passage V_{passL} à une ligne de sélection de grille de drain ;
appliquer une tension Vₚₚ à une ligne de source commune ;
appliquer la tension de passage V_{passH} à une ligne de sélection de grille de source.

4. Procédé de programmation à basse tension selon la revendication 2, dans lequel la tension de seuil est inférieure à la tension cible, comprenant en outre les étapes ci-dessous consistant à :
maintenir la ligne de bits sélectionnée (303) à une tension Vₚₚ ;
mettre à la terre toutes les lignes de bits non sélectionnées (301, 302) ;
appliquer une tension de passage V_{passH} à une ligne de sélection de grille de drain ;
appliquer une tension de passage V_{passL} à une ligne de sélection de grille de source ;
mettre à la terre une ligne de source commune.

5. Procédé selon la revendication 3 ou 4, comprenant les étapes ci-dessous consistant à :
incrémenter la tension de programme V_{pgm} et les tensions V_{passH} et V_{passL} ; et
revenir à l'étape de détermination (b).

6. Procédé selon l'une quelconque des revendications 3 à 5, dans lequel la tension V_{pgm} varie de 8 V à 14 V, la tension V_{passL} varie de 4 V à 10 V, la tension V_{passH} varie de 5 V à 10 V, la tension Vₚₚ varie de 3,5 V à 5,5 V et la tension V_{dd} varie de 1,8 V à 3,6 V.

7. Système destiné à fournir une programmation à basse tension d'une cellule de mémoire non volatile sélectionnée (332) dans une matrice de mémoire NON-ET présentant un noeud de grille couplé à une ligne de mots WL(n), et un noeud de drain connecté à une ligne de bits sélectionnée (303), comportant :
un module de programmation ;
une interface agencée de manière à coupler électriquement la matrice de mémoire au module de programmation ;
**caractérisé par** :
un processeur inclus dans le module de programmation, électriquement couplé à l'interface, et agencé de manière à exécuter des instructions de programmation qui amènent des charges à haute énergie à être injectées à partir d'une région de drain d'une cellule de mémoire d'injection (330) présentant un noeud de grille couplé à une ligne de mots voisine successive WL(n-1) dans une grille flottante de la cellule de mémoire non volatile sélectionnée (332) sur la ligne de mots WL(n) ;
dans lequel les instructions de programmation incluent en outre un code informatique exécutable par le processeur pour :
tout en appliquant simultanément une tension de passage V_{passH} à toutes les lignes de mots non sélectionnées qui englobent la ligne de bits sélectionnée (303), à l'exception de la ligne de mots voisine successive WL(n-1), et en appliquant une tension de programme V_{pgm} à la ligne de mots sélectionnée WL(n), augmenter progressivement une tension de noeud de grille de ligne de mots voisine successive WL(n-1) d'environ 0 V à environ une tension V_{read}.

8. Système selon la revendication 7, dans lequel les instructions de programmation incluent un code informatique exécutable par le processeur pour :
(b) déterminer une tension de seuil de la cellule de mémoire non volatile sélectionnée (332) ; et
(c) verrouiller la cellule de mémoire non volatile sélectionnée (332) si la tension de seuil est supérieure à une tension de seuil cible.

9. Système selon la revendication 8, dans lequel les instructions de programmation incluent en outre un code informatique exécutable par le processeur, lorsque la tension de seuil est inférieure à la tension cible, pour :
maintenir la ligne de bits sélectionnée (303) à la terre ;
appliquer une tension V_{dd} à toutes les lignes de bits non sélectionnées (301, 302) ;
appliquer une tension de passage V_{passL} à une ligne de sélection de grille de drain ;
appliquer une tension Vₚₚ à une ligne de source commune ;
appliquer la tension de passage V_{passH} à une ligne de sélection de grille de source.

10. Système selon la revendication 8, dans lequel les instructions de programmation incluent en outre un code informatique exécutable par le processeur, lorsque la tension de seuil est inférieure à la tension cible, pour :
maintenir la ligne de bits sélectionnée (303) à une tension Vₚₚ ;
mettre à la terre toutes les lignes de bits non sélectionnées (301, 302) ;
appliquer une tension de passage V_{passH} à une ligne de sélection de grille de drain ;
appliquer une tension de passage V_{passL} à une ligne de sélection de grille de source ;
mettre à la terre une ligne de source commune.

11. Système selon la revendication 9, dans lequel les instructions de programmation incluent en outre un code informatique exécutable par le processeur pour :
incrémenter la tension de programme V_{pgm} et les tensions V_{passH} et V_{passL} ; et
revenir à l'étape de détermination (b).

12. Système selon l'une quelconque des revendications 9 à 11, dans lequel la tension V_{pgm} varie de 8 V à 14 V, la tension V_{passL} varie de 4 V à 10 V, la tension VpasSL varie de 5 V à 10 V, la tension Vₚₚ varie de 3,5 V à 5,5 V et la tension V_{dd} varie de 1,8 V à 3,6 V.
